(19) Europäisches Patentamt
European Patent Office
Office européen des brevets

(11) **EP 2 330 734 A1**

(12) **EUROPEAN PATENT APPLICATION**

(43) Date of publication:
**08.06.2011 Bulletin 2011/23**

(51) Int Cl.:
*H03F 1/32* (2006.01)    *H03F 3/19* (2006.01)
*H03F 3/217* (2006.01)

(21) Application number: **09290880.5**

(22) Date of filing: **25.11.2009**

| | |
|---|---|
| (84) Designated Contracting States:<br>**AT BE BG CH CY CZ DE DK EE ES FI FR GB GR HR HU IE IS IT LI LT LU LV MC MK MT NL NO PL PT RO SE SI SK SM TR**<br>Designated Extension States:<br>**AL BA RS**<br><br>(71) Applicant: **Alcatel Lucent**<br>**75008 Paris (FR)** | (72) Inventor: **Dartois, Luc**<br>**78955 Carrieres sous Poissy (FR)**<br><br>(74) Representative: **Richardt, Markus Albert**<br>**Richardt Patents Trademarks**<br>**Leergasse 11**<br>**65343 Eltville am Rhein (DE)** |

(54) **Power amplifier apparatus comprising digital delta-sigma modulation and a pulse with modulator and method thereof**

(57)    The invention concerns a power amplifier apparatus (100) comprising an input for receiving a digital signal, a power amplifier component for amplifying an analogue signal, an output for outputting the amplified analogue signal, and a signal processing circuit,wherein the signal processing circuit processes the digital signal being received at the input, and wherein the analogue signal is put out at the output, wherein the signal processing circuit comprises a digital sigma-delta modulation means (102), wherein the digital sigma-delta modulation means modulates the digital signal into a modulated digital signal, wherein the modulated digital signal is sampled from a base band to an output radio frequency band after the digital sigma-delta modulation, and wherein the sampled and modulated digital signal is transformed into the analogue signal by the pulse width modulator (108) and amplified by the power amplifier component.

**Fig. 1**

EP 2 330 734 A1

## Description

### Field of the invention

The invention relates to a signal processing method, more precisely to a signal modulation and amplifying method.

### Background and related art

In a bandpass class-S amplifier the input signal is transformed to a binary pulse sequence by a modulator. This pulse sequence is amplified by a switching amplifier. Afterwards a bandpass filter reconstructs the useful signal from the amplified wideband pulse sequence. The use of a pulse modulation scheme allows the amplification of amplitude modulate signals by a switching amplifier. In general, modulation schemes that can be extracted by simple filtering are of great interest.

### Summary of the invention

Embodiments of the invention provide a signal processing method, the method comprising the following steps: receiving a digital signal via an input, modulating the digital signal by sigma-delta modulation into a modulated digital signal, digitally transposing the modulated digital signal from a base bandwidth to a radio frequency bandwidth after the sigma-delta modulation, transforming the sampled and modulated digital signal into an analogue signal by means of a pulse width modulator, and amplifying the analogue signal.

In other words, a digital signal, which may be a complex digital signal, is received via an input. Then, the digital signal is modulated by a sigma-delta modulation into a modulated digital signal. Afterwards, the now modulated digital signal is sampled from a base bandwidth to a radio frequency bandwidth. This up-sampling can for example be performed with an up-sampling factor of 2. Preferably, the signal has already been up-sampled during the digital sigma-delta modulation, for example by the factor of 10. The important parameter is that the sampling rate for digitally transposing the baseband signal to a radio frequency signal is close to 4 times the wanted carrier radio frequency. The sampled and modulated digital signal is then transformed into an analogue signal. This step is preferably performed by a pulse width modulator. The analogue signal is then amplified.

According to embodiments of the invention the signal processing method further comprises the steps of storing a plurality of samples of the modulated digital signal and pre-distorting the modulated signal by using the plurality of samples.

By storing the plurality of samples and using them for pre-distortion, the linearity of the digital signal is increased. Interferences on other radio channels are cancelled and the in-band signal distortion is reduced.

According to embodiments of the invention the sampled and modulated digital signal is transformed into the analogue signal by a pulse width modulation.

According to embodiments of the invention the pulse width modulation is performed by transforming a plurality of Dirac digital samples into a plurality of rectangular binary pulses. A Dirac digital sample is a digital sample consisting of a Dirac delta function. The width of each rectangular binary pulse of the plurality of rectangular binary pulses is centered on the corresponding Dirac digital sample of the plurality of Dirac digital samples. This means, that the middle of each rectangular binary pulse is located at a single position of the corresponding Dirac digital sample. The width of each rectangular binary pulse of the plurality of rectangular binary pulses is proportional to a power of the corresponding Dirac digital sample of the plurality of Dirac digital samples. Thus, the energy of each rectangular binary pulse of the plurality of rectangular binary pulses is the same as the energy of the corresponding Dirac digital sample. Hence, the signal energy is not changed and the energy of each Dirac digital sample corresponds to the energy of the corresponding rectangular binary pulse. Thus, the pulse-width modulation transformation does not introduce sample distortion and the pulse-width modulation transformation reproduces a transposed sigma-delta modulation spectrum with adequate quality

According to embodiments of the invention the width of each rectangular binary pulse of the plurality of rectangular binary pulses is based on a counter means. The counter means comprise a clock. The clock has a fixed frequency and outputs a pulse to the counter means according to the fixed frequency. Thus, the counter divides time into a plurality of time segments, wherein the width of each time segment depends on the frequency of the clock. A frequency of 2 Hz for example would result in a time segment width of half a second. Hence, the width of the time segments is the inverted frequency value of the clock. In a preferred embodiment the clock frequency is in the range of 10 to 80GHz

The frequency has to be defined such that every Dirac digital sample can be represented by a corresponding rectangular binary pulse. Therefore, the frequency of the clock of the counter means is at least $2^n$ times the sampling rate of the Dirac digital samples.

N is defined by a number of states of the plurality of Dirac digital samples. The number of states of the plurality of Dirac digital samples is $1+2^n$.

If there are for example nine Dirac digital sample states, n is 3. The signal is then represented by all integer amplitudes from -4 to +4. Then, the frequency of the clock has to be at least eight times the sample rate of the plurality of Dirac digital samples. For a sample rate of eight Giga-samples per second, the minimum frequency would be 64 GHz. For representing the nine different states of the Dirac digital samples rectangular binary pulses of different widths are used. Eight rectangular binary pulses of a non-null pulse width are used. The smallest non-null width would then be $\frac{1}{64 \cdot 10^9}$ seconds and the longest width would be $\frac{8}{64 \cdot 10^9}$ seconds. Additionally, there are pulses with a pulse width of 0. In the case of n=3, the null-pulse corresponds to the Dirac digital sample value -4, while the longest pulse of $\frac{8}{64 \cdot 10^9}$ seconds corresponds to the Dirac digital sample value +4.

According to embodiments of the invention the pulse width modulation comprises enlarging the pulse width proportionally to a spectral attenuation at the frequency of the carrier signal. The radio frequency is used as the carrier frequency for the rectangular binary pulses. To compensate the attenuation of the spectrum the energy of each rectangular binary pulse is increased by enlarging the pulse width proportionally to the spectral attenuation at the radio frequency. The correction corresponds to a fraction of circuit technology native rise and fall times. In a preferred embodiment an integrated circuit based on indium phosphide technology is used.

According to embodiments of the invention the enlarging of the pulse width is performed by a tabulated enlarger, wherein a fixed enlargement coefficient is precalculated for each rectangular binary pulse of the plurality of rectangular binary pulses having a non-null pulse width.

Therefore, a bias voltage offset addition is applied to the pulse, a selected voltage offset is added to the rectangular binary pulse during the rise of the signal and the fall of the signal is symmetrically delayed in order to keep the rectangular binary pulse centered to the corresponding Dirac digital sample.

According to embodiments of the invention the digital signal is modulated by the sigma-delta modulation and has a base band frequency. An in-phase and a quadrature part of the digital signal are modulated with a multiple digital structure, which comprises a cascading integrated structure with a plurality of ternary adders and a plurality of accumulators. The number of structures is defined by the number of wanted filter poles.

According to embodiments of the invention the sigma-delta modulation comprises a binary weighted feedback. Thus, the digital structure of the sigma-delta modulation does not contain any multiplier. The modulation is performed only by accumulative structures to maximize the usable sampling and processing rate.

According to embodiments of the invention the sigma-delta modulation comprises a feedback and an output quantizer with a selectable number of bits and states.

In another aspect the invention relates to a power amplifier apparatus comprising an input for receiving a digital signal,, a pulse-width modulator, a power amplifier component for amplifying an analogue signal, an output for outputting the amplified analogue signal and a signal processing circuit. The signal processing circuit processes the digital signal being received at the input, and wherein the analogue signal is put out at the output, wherein the signal processing circuit comprises a digital sigma-delta modulation means, wherein the digital sigma-delta modulation means modulates the digital signal into a modulated digital signal, wherein the modulated digital signal is sampled from a base band to an output radio frequency band after the digital sigma-delta modulation, and wherein the sampled and modulated digital signal is transformed into the analogue signal by the pulse-width modulator and amplified by the power amplifier component.

According to embodiments of the invention the power amplifier apparatus comprises a storage and a predistortion means, wherein a plurality of samples of the modulated digital signal are stored in the storage and are used by the predistortion means for predistorting the modulated digital signal.

According to embodiments of the invention the power amplifier apparatus comprises counter means, wherein a frequency of a clock of the counter means is at least 2 raised to the power of n times the sample rate of the plurality of Dirac digital samples, wherein n is defined by a number of states of the plurality of Dirac digital samples, and wherein the number of states of the plurality of Dirac digital samples is 1 plus 2 raised to the power of n.

According to embodiments of the invention the power amplifier apparatus comprises an enlarger, the enlarger enlarging the pulse width proportionally to a spectral attenuation at the radio frequency.

According to embodiments of the invention the power amplifier apparatus performs a method according to embodiments of the invention.

Embodiments of the invention are advantageous because many analogue and radio frequency tunings are performed by associated dedicated hardware. A full wideband and reconfigurable is applied from the input on.

The digital sigma-delta modulation is easy to design and tune. The number of states is programmable to accommodate pulse-width modulation capabilities. The input quantization can be adjusted to the wanted final radio frequency inband noise. The number of poles of the digital sigma-delta modulator is configurable to tune the adjacent channel power (ACLR) versus the wanted modulator efficiency, which also influences the limit of switching the power amplifier's electrical efficiency.

The power amplifier apparatus can be applied in ultra wideband with few static tunings. For example with a 12 poles sigma delta modulator operating at 4GHz with 9 states output, one can generate a radio frequency modulated signal around 2GHz with useful bandwidth up to 180Mhz with inband signal to noise ratio between 50 and 70dB.

## Brief description of the drawings

In the following preferred embodiments of the invention will be described, by way of example only, and with reference to the drawings in which:

Fig. 1    is a block diagram of a power amplifier apparatus;

Fig. 2    is a block diagram of the sigma-delta modulation circuitry;

Fig. 3    is a schematic view of a plurality of digital Dirac samples and corresponding rectangular binary pulses;

Fig. 4    is a diagram showing the attenuation of the rectangular binary pulses for a frequency spectrum; and

Fig. 5    is a block diagram of a signal processing method.

## Detailed description

Like numbered elements in these Figs. are either identical elements or perform the same function. Elements which have been discussed previously will not necessarily be discussed in later Figs. if the function is identical.

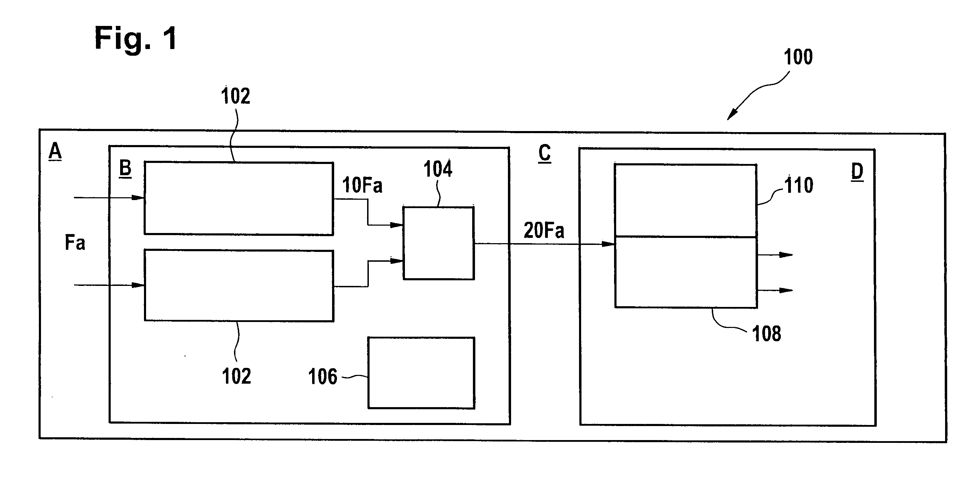

Fig. 1 is a block diagram of a power amplifier apparatus 100. The power amplifier apparatus comprises sigma-delta modulation (SDM) means 102, an oversampler 104, a sample RAM 106 (random access memory), a pulse-width-modulator (PWM) 108 and a clock 110. In operation, a signal A is input into the SDM means 102 and modulated into an intermediate signal B and output to the PWM 108, which then again outputs an output signal D.

Input signal A is a complex digital baseband signal to be transmitted. As it is a complex signal, signal A consists of a real part AI and an imaginary part AQ:

$$A = AI + j*AQ \text{ with } j*j = -1$$

The real part AI is an in-phase signal, while the imaginary part AQ is a quadrature signal.

Signal A has a frequency of 414.72MHz (Fa), while the output signal C is a real radio frequency signal. Advantageously, when the apparatus is applied in a transmitter, output signal C is a real radio frequency representation of the signal to be transmitted. First, signal A is oversampled by the delta-sigma modulation means 102 by factor 10 in the shown example by an oversampling filter. Thus, the over sampled signal A has the frequency 1OFa.

This oversampled signal A is modulated by delta-sigma modulation means 102 to provide signal B. As a sigma-delta modulation (SDM) in the baseband has a linear behaviour, B is:

$$B = SDM(A) = SDM(AI + j*AQ) = SDM(AI) + j*SDM(AQ)$$

This means two real SDMs are run independently on AI and AQ:

$$BI = SDM(AI) \text{ and } BQ = SDM(AQ)$$

Thus, signal B has still the same frequency of the oversampled signal A. Additionally, signal B is quantified on 3 bits plus zero value. This results in $1+2^3=9$ states, i.e. all 9 integer values from -4 to +4. Then this SDM quantized signal B needs to be transposed digitally to radio frequency as simple as possible. This is done by oversampler 104 Due to the very high sampling rate, this is performed without any intensive mathematical operation like multiply or even add. Thus, a signal of a frequency of 20Fa is provided at the output of oversampler 104.

Therefore signal B is oversambled by two in oversampler 104, so that the sampling rate is four times the wanted carrier radio frequency (RF). Thereby, the transposition carrier becomes a simple periodic sequence of complex values in the four quadrants so that digital transposition becomes a simple selection of the real or imaginary value of the oversampled signal B. The oversampled and RF transposed signal B is called signal C.

Due to the oversampling by 2 using a repetition of 2 consecutive B samples, the spectrum of the oversampler is then a low path sinc function with a spectral maximum at 0Hz and a spectral null at the wanted carrier frequency, for example 2 GHz. Thus, C is a sequence of:

$$C=BI(n) \quad -BQ(n) \quad -BI(n+1) \quad -BQ(n+1) \quad ...$$

wherein n is a number of the sample, with wich transposing is started.

C is the succession of the listed B samples sequence with periodic sign changes. The up sampling of B and its baseband to radio frequency is described by the example of two consecutive B samples or four consecutive C samples:

$$B=B1 \quad B2 \quad \text{(e.g. sampled at 4GHz)}$$
$$B= B1\ I+j^*B1Q \quad B21+j^*B2Q$$

The two times oversampling of B with repetition of B samples is named BB:

$$BB= B\ 1I+j'B1Q \quad B1I+j^*B1Q \quad B2I+j^*B2Q \quad B2I+j^*B2Q$$

The digital local oscillator used for the digital transposition of BB in base band up to C in radio frequency at 2GHz is named LO. (BB and C e.g. sampled at $4^*2GHz=8GHz$):

$$LO= 1+j^*0 \quad 0+j^*1 \quad -1+j^*0 \quad o-rj^*1$$

Then, C is simply the real part of the scalar product of BB & C sequences: $C=real(BB^*LO)$

$$C= B11 \quad -B1Q \quad -B21 \quad +B2Q$$

Here, the indexes n and n+1 been replaced by 1 and 2 respectively.

Because signal B consists of two parts, an imaginary and a real part, two samples of C are derived from one complex sample of the SDM output signal B using the above mentioned transposition signal represented by samples in the four quadrants. Therefore, a 2GHz signal is sampled at 8GHz.

Samples of signal B are stored in sample RAM 106 and may be used in further signal processing steps for predistortion.

Signal C consists of a plurality of Dirac digital samples in different states. Each state corresponds to an energy of the Dirac digital pulse. Pulse-width-modulator (PWM) 108 modulates the Dirac digital samples into rectangular binary pulses with different widths. In this case, there is one pulse width of 0 and eight non-null pulse widths. The eight non-null pulse widths generated by the PWM 108 have each a given spectrum.

The energy and the spectrum of the input Dirac digital samples of signal C, which have mathematically a flat spectrum, are reproduced by PWM 108. The pulse widths are defined by clock 110. A single clock period is the minimum width of a non-null pulse. Each width of a non-null pulse must be a multiple of the clock period. Thus, the higher the clock period is the smaller pulses are possible. Then, due to this conversion of the Dirac digital samples into rectangular binary pulses, a bias is applied to the signal, as the transformed signal is a radio frequency signal around 2GHz and not a DC signal.

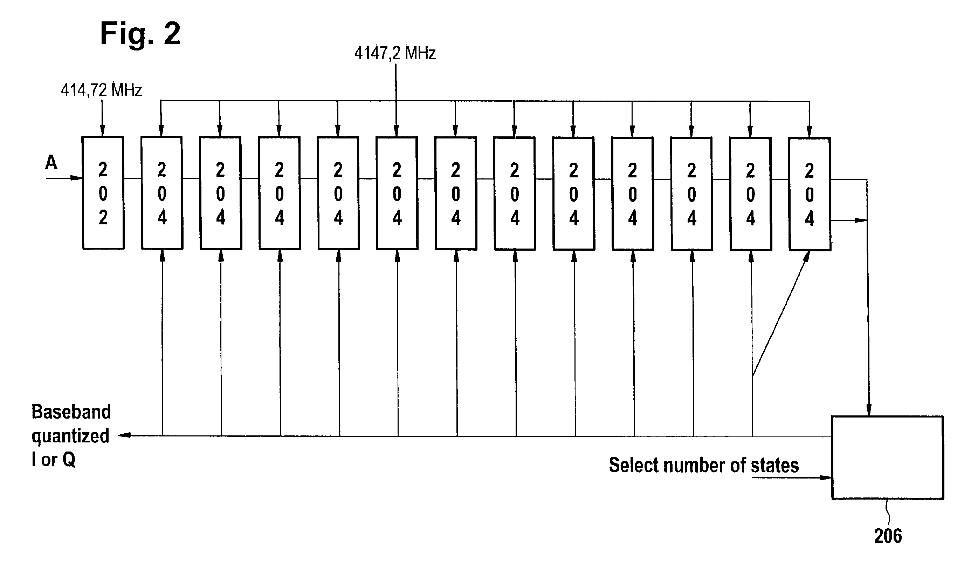

Fig. 2 is a block diagram of a sigma delta modulation circuitry 200. The signal A is registered by register 202 with a frequency of 414.72 MHz. Afterwards, a plurality of integrators 204 processes the signal. The integrators 204 are synchronized by a clock running at 4,147.2 MHz. This means, the signal is up-sampled by 10. The number of states of the Dirac digital samples can be selected via quantizer 206.

Thus, circuitry 200 outputs a base band quantized in phase or quadrature signal. The base band frequency thereby is 4,147.2 MHz.

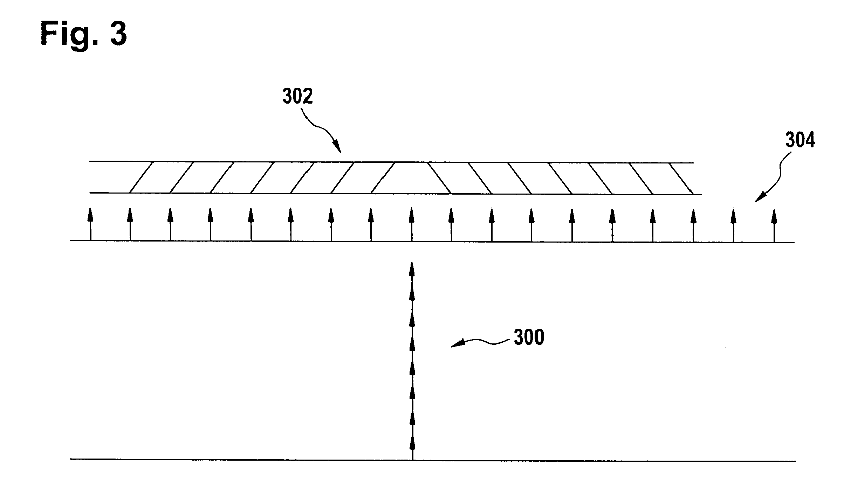

Fig. 3 is a schematic view showing a plurality of Dirac digital samples 300 and a plurality of corresponding rectangular binary pulses 302. The pulses 302 are centered over the Dirac digital samples 300. The width of the pulses 302 is defined by a clock. Possible widths are represented by arrows 304. The Dirac digital sample with the lowest energy corresponds to a rectangular binary pulse having a pulse width of 0. Dirac digital samples with a higher energy correspond to rectangular binary pulses with a bigger width. Thus, the second lowest Dirac digital sample 300 corresponds to the rectangular binary pulse with twice the width between two arrows 304. The non-null pulse widths are defined by a clock (see Fig. 1). A single clock period corresponds to the single non-null pulse width and each non-null pulse width must be a multiple of the clock period. Thus, only a limited number of pulse widths are possible. The number of possible pulse widths can be increased by increasing the clock frequency.

The fact that each pulse 302 does not have a real rectangular shape is due to the rise and fall time of the circuit technology.

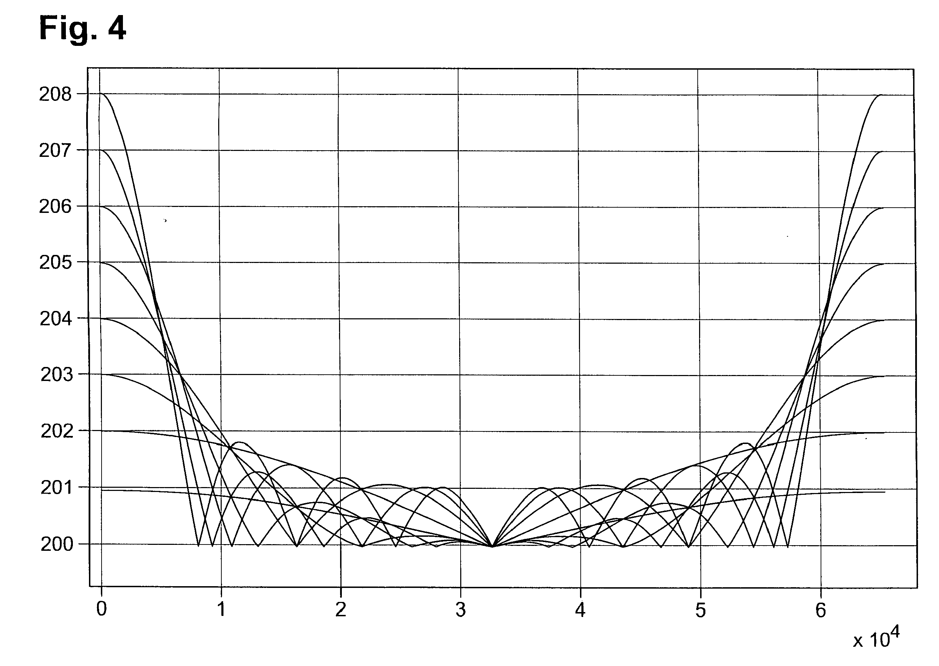

Fig. 4 is a diagram showing the attenuation of pulses over a spectrum of 66 GHz. By knowing this diagram the attenuation of a certain carrier frequency versus DC can easily be determined. Also the attenuations for each of the eight non-null pulse widths can be determined by this diagram.

The horizontal axis goes from 0 to 65536. Each value corresponds to a number of points in the spectrum from zero to 64GHz, wherein 64GHz is represented by point 65536.

The vertical axis represents the spectral density of each different pulse width with an offset of 200. This means the value 200 represents 0 and the value 208 represents 8. The value 201 represents the spectral density maximum of the smallest pulse width of 1 clock cycle, while the value 208 represents the spectral density maximum of the largest pulse width of 8 clock cycles.

Each PWM spectrum has a specific attenuation. For each carrier frequency used the attenuation can be derived from the diagram. To compensate the attenuation the energy of each PWM pulse is increased by enlarging the pulse width proportionally to the spectral attenuation at the carrier frequency.

In the case of nine states for signal B, if the attenuation is above 12 percents, the attenuation can be compensated by manipulating the pulse width by 1/8th of the clock period, if the correction corresponds just to a fraction of circuit technology native rise and fall time. So, a simple bias voltage offset addition to feed a threshold trigger is enough to enlarge a bit each native pulse width. This symmetric modulation of rise and fall time of the native pulse width avoids parasitic phase or delay modulation that would create unwanted inband distortion and spectral regrowth of the noise floor.

In other words, if the largest pulses of eight clock cycles is to be changed to 12% or more this would mean to first increase pulse width by 1 clock cycle, as 12% is close to 1/8.

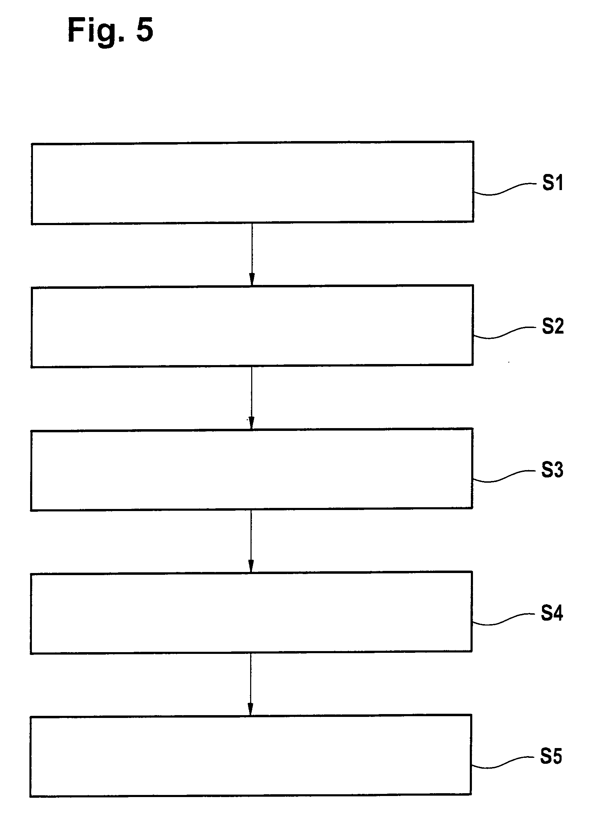

Fig. 5 is a block diagram of a signal processing method according to embodiments of the invention. Step S1 comprises receiving a digital signal via an input. Step S2 comprises modulating the digital signal by sigma-delta modulation into a modulated digital signal. Step S3 comprises sampling the modulated digital signal from a base bandwidth to a radio frequency bandwidth after the sigma-delta modulation. Step S4 comprises transforming the sampled and modulated digital signal into an analogue signal by means of a pulse width modulation. Step S5 comprises amplifying the analogue signal.

**List of reference numerals**

100    power amplifier

102    sigma-delta modulator

104    oversampler

106    sample RAM

108    pulse-width modulator

110    clock

200    circuitry

202    register

204     integrator

206     quantizer

300     Dirac digital samples

302     pulses

304     arrows

**Claims**

1.  Signal processing method, wherein the method comprises

    a. Receiving (S1) a digital signal via an input,
    b. modulating (S2) the digital signal by sigma-delta modulation into a modulated digital signal,
    c. sampling (S3) the modulated digital signal from a base bandwidth to a radio frequency bandwidth after the sigma-delta modulation,
    d. transforming (S4) the sampled and modulated digital signal into an analogue signal, and
    e. amplifying (S5) the analogue signal.

2.  Signal processing method according to claim 3, the method further comprising the steps of:

    a. storing a plurality of samples of the modulated digital signal,
    b. predistorting the modulated digital signal by using the plurality of samples.

3.  Signal processing method according to any one of the preceding claims,
    wherein the sampled and modulated digital signal is transformed into the analogue signal by a pulse width modulation.

4.  Signal processing method according to any one of the preceding claims,
    wherein the pulse width modulation is performed by transforming a plurality of Dirac digital samples into a plurality of rectangular binary pulses, wherein the width of each rectangular binary pulse of the plurality of rectangular binary pulses is centred on the corresponding Dirac digital sample of the plurality of Dirac digital samples, and wherein the width of each rectangular binary pulse of the plurality of rectangular binary pulses is proportional to a power of the corresponding Dirac digital sample of the plurality of Dirac digital samples, so that the energy of each rectangular binary pulse of the plurality of rectangular binary pulses is the same as the energy of the corresponding Dirac digital sample.

5.  Signal processing method according to any one of the claims 3 or 4, wherein the width of each rectangular binary pulse of the plurality of rectangular binary pulses is based on a counter means, wherein a frequency of a clock of the counter means is at least 2 raised to the power of n times the sample rate of the plurality of Dirac digital samples, wherein n is defined by a number of states of the plurality of Dirac digital samples, and wherein the nut states of the plurality of Dirac digital samples is 1 plus 2 raised to the power of n.

6.  Signal processing method according to any one of the claims 3-5, wherein the pulse width modulation comprises enlarging the pulse width proportionally to a spectral attenuation at the radio frequency, and wherein the base band sigma-delta modulation applied on the input complex signal is done by applying in parallel a real sigma delta modulation on each of the real and imaginary parts of the input signal.

7.  Signal processing method according to claim 6, wherein enlarging the pulse width is performed by a tabulated enlarger, wherein a fixed enlargement coefficient is precalculated for each rectangular binary pulse of the plurality of rectangular binary pulses having a non null pulse width.

8.  Signal processing method according to any one of the preceding claims,
    wherein the digital signal is modulated by the sigma-delta modulation and has a baseband frequency, wherein an in-phase and a quadrature part of the digital signal is modulated with a multi pole digital structure, wherein the multi pole digital structure comprises a cascading integrator structure with a plurality of ternary adders and a plurality of accumulators.

9. Signal processing method according to claim 8, wherein the sigma-delta modulation comprises a binary weighted feedback.

10. Signal processing method according to any one of the claims 8 or 9, wherein the delta-sigma modulation comprises a feedback and an output quantizer with a selectable number of bits and states.

11. Power amplifier apparatus (100) comprising

    a. an input for receiving a digital signal,
    b. a power amplifier component for amplifying an analogue signal,
    c. a pulse width modulator (108)
    d. an output for outputting the amplified analogue signal, and
    e. a signal processing circuit,

    wherein the signal processing circuit processes the digital signal being received at the input, and wherein the analogue signal is put out at the output, wherein the signal processing circuit comprises a digital sigma-delta modulation means (102), wherein the digital sigma-delta modulation means modulates the digital signal into a modulated digital signal, wherein the modulated digital signal is sampled from a base band to an output radio frequency band after the digital sigma-delta modulation, and wherein the sampled and modulated digital signal is transformed into the analogue signal by the pulse width modulator (108) and amplified by the power amplifier component.

12. Power amplifier apparatus according to claim 11 comprising a storage (106) and a predistortion means, wherein a plurality of samples of the modulated digital signal are stored in the storage and are used by the predistortion means for predistorting the modulated digital signal.

13. Power amplifier apparatus according to any one of the claims 11 or 12 comprising counter means (110), wherein a frequency of a clock of the counter means is at least 2 raised to the power of n times the sample rate of the plurality of Dirac digital samples, wherein n is defined by a number of states of the plurality of Dirac digital samples, and wherein the number of states of the plurality of Dirac digital samples is 1 plus 2 raised to the power of n.

14. Power amplifier apparatus according to any one of the claims 11-13 comprising an enlarger, the enlarger enlarging the pulse width proportionally to a spectral attenuation at the radio frequency.

15. Power amplifier apparatus according to any one of the preceding claims 11-14, wherein the power amplifier apparatus performs a method according to any one of the claims 1-10.

**Fig. 1**

EP 2 330 734 A1

# Fig. 2

414,72 MHz

4147,2 MHz

A →

| 2 0 2 | 2 0 4 | 2 0 4 | 2 0 4 | 2 0 4 | 2 0 4 | 2 0 4 | 2 0 4 | 2 0 4 | 2 0 4 | 2 0 4 | 2 0 4 | 2 0 4 |

Baseband
quantized ←
I or Q

Select number of states →

206

EP 2 330 734 A1

# Fig. 3

Fig. 4

EP 2 330 734 A1

# Fig. 5

```
┌─────────────────────────────────┐
│                                 │ ─── S1
└─────────────────────────────────┘
                 │
                 ▼
┌─────────────────────────────────┐
│                                 │ ─── S2
└─────────────────────────────────┘
                 │
                 ▼
┌─────────────────────────────────┐
│                                 │ ─── S3
└─────────────────────────────────┘
                 │
                 ▼
┌─────────────────────────────────┐
│                                 │ ─── S4
└─────────────────────────────────┘
                 │
                 ▼
┌─────────────────────────────────┐
│                                 │ ─── S5
└─────────────────────────────────┘
```

Europäisches
Patentamt

European
Patent Office

Office européen
des brevets

## EUROPEAN SEARCH REPORT

**Application Number**

EP 09 29 0880

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 501 187 A1 (NORTHROP GRUMMAN CORP [US]) 26 January 2005 (2005-01-26) * paragraph [0023] - paragraph [0032]; figures 1, 2 * | 1,2 | INV.<br>H03F1/32<br>H03F3/19<br>H03F3/217 |
| X | BERLAND C ET AL: "Digital signal processing techniques to compensate for RF imperfections in advanced transmitter architectures", WIRELESS TECHNOLOGY, 2008. EUWIT 2008. EUROPEAN CONFERENCE ON, IEEE, PISCATAWAY, NJ, USA, 27 October 2008 (2008-10-27), pages 41-44, XP031408469, ISBN: 978-2-87487-008-8 * Section II. Transmitter Architecture, A. Direct up conversion transmitter, 2) Transmitters using Sigma-Delta modulators; figure 2 * | 1-3,11, 12,15 | |
| X | WO 2009/031952 A1 (ERICSSON TELEFON AB L M [SE]; MALMQVIST HAAKAN [SE]; REXBERG LEONARD []) 12 March 2009 (2009-03-12) * page 7, line 14 - line 33; figure 1 * | 1-3,11, 12,15 | TECHNICAL FIELDS SEARCHED (IPC)<br><br>H03F |
| X | US 2006/171484 A1 (PUMA GIUSEPPE L [DE] PUMA GIUSEPPE LI [DE]) 3 August 2006 (2006-08-03) * paragraph [0045] - paragraph [0061]; figure 1 * | 1-3,11, 12,15 | |

-/--

~~The present search report has been drawn up for all claims~~

| Place of search | Date of completion of the search | Examiner |
|---|---|---|
| Munich | 23 December 2010 | Lorenzo, Carlos |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

## EUROPEAN SEARCH REPORT

Application Number

EP 09 29 0880

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JOHAN SOMMAREK ET AL: "A 20 MHz BP-PWM and BP-DSM Class-D PA in 0.18 m CMOS", ELECTRONICS, CIRCUITS AND SYSTEMS, 2005. ICECS 2005. 12TH IEEE INTERNATIONAL CONFERENCE ON, IEEE, PISCATAWAY, NJ, USA, 11 December 2005 (2005-12-11), pages 1-4, XP031327403, ISBN: 978-9972-611-00-1 * the whole document * | 1,3,11,15 | |
| X | EP 1 662 665 A1 (TECHNOCONCEPTS INC [US]) 31 May 2006 (2006-05-31) * paragraph [0030] - paragraph [0034]; figure 6 * | 1,3,11,15 | |

TECHNICAL FIELDS SEARCHED (IPC)

~~The present search report has been drawn up for all claims~~

| Place of search | Date of completion of the search | Examiner |
|---|---|---|
| Munich | 23 December 2010 | Lorenzo, Carlos |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-7, 11-15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 09 29 0880

The Search Division considers that the present European patent application does not comply with the
requirements of unity of invention and relates to several inventions or groups of inventions, namely:

    1. claims: 1, 2

        Signal processing method comprising receiving a digital
        signal, modulating it by sigma-delta modulation, upsampling
        it, converting it to an analog signal and amplifying the
        analog signal, where the modulated signal is stored and
        predistorted.
                                ---

    2. claims: 3-7, 11-15

        Signal processing method comprising receiving a digital
        signal, modulating it by sigma-delta modulation, upsampling
        it, converting it to an analog signal and amplifying the
        analog signal, where the digital to analog convertion is
        carried out by pulse width modulation.
                                ---

    3. claims: 8-10

        Signal processing method comprising receiving a digital
        signal, modulating it by sigma-delta modulation, upsampling
        it, converting it to an analog signal and amplifying the
        analog signal, where the digital signal has in-phase and
        quadrature parts which are modulated with a multi pole
        digital structure.
                                ---

EP 2 330 734 A1

## ANNEX TO THE EUROPEAN SEARCH REPORT
## ON EUROPEAN PATENT APPLICATION NO.

EP 09 29 0880

This annex lists the patent family members relating to the patent documents cited in the above-mentioned European search report.
The members are as contained in the European Patent Office EDP file on
The European Patent Office is in no way liable for these particulars which are merely given for the purpose of information.

23-12-2010

| Patent document cited in search report | | Publication date | Patent family member(s) | | Publication date |
|---|---|---|---|---|---|
| EP 1501187 | A1 | 26-01-2005 | DE 602004012671 T2<br>JP 2005045817 A<br>US 2005129140 A1<br>US 2005017800 A1 | | 07-05-2009<br>17-02-2005<br>16-06-2005<br>27-01-2005 |
| WO 2009031952 | A1 | 12-03-2009 | EP 2186284 A1<br>US 2010201444 A1 | | 19-05-2010<br>12-08-2010 |
| US 2006171484 | A1 | 03-08-2006 | CN 1791087 A<br>DE 102004060698 B3<br>EP 1672862 A2<br>JP 2006174484 A | | 21-06-2006<br>14-06-2006<br>21-06-2006<br>29-06-2006 |
| EP 1662665 | A1 | 31-05-2006 | KR 20060059155 A<br>US 2006115005 A1<br>WO 2006057649 A2 | | 01-06-2006<br>01-06-2006<br>01-06-2006 |

EPO FORM P0459

For more details about this annex : see Official Journal of the European Patent Office, No. 12/82

18